# EUROPÄISCHE PATENTSCHRIFT

(11) **EP 3 249 700 B1**
(45) Veröffentlichungstag und Bekanntmachung des Hinweises auf die Patenterteilung: **30.10.2019**
(21) Anmeldenummer: 17000851.0
(22) Anmeldetag: 18.05.2017
(51) Int. Cl.: H01L 33/04, H01L 33/14, H01L 33/30

(54) **LEUCHTDIODE**
LIGHT EMITTING DIODE
DIODE ÉLECTROLUMINESCENTE

(30) Priorität: 27.05.2016 DE 102016006295
(43) Veröffentlichungstag der Anmeldung: 29.11.2017
(73) Patentinhaber: AZUR SPACE Solar Power GmbH, 74072 Heilbronn (DE)
(72) Erfinder: Fuhrmann, Daniel, 74081 Heilbronn (DE); Lauermann, Thomas, 74076 Heilbronn (DE)
(74) Vertreter: Koch Müller Patentanwaltsgesellschaft mbH

(56) Entgegenhaltungen:
- EP-A2- 1 906 460
- EP-A2- 2 015 372
- US-A1- 2004 159 843
- US-A1- 2010 032 648
- US-B1- 6 369 403

## Beschreibung

Die Erfindung betrifft eine Leuchtdiode (LED).

Aus der DE 102 44 200 A1, der DE 10 2010 032 497 A1, der EP 1 906 460 A2, der US 6,369,403 B1, der US 2010/032648 A1, der EP 2 015 372 A2 und aus K. Streubel, et al, "High Brightness AlGaInP Light-Emitting Diodes", IEEE Journal on selected Topics in Quantum Electronics, Vol. 8, No. 2 March / April 2002 sind verschiedene LED Strukturen bekannt.

Vor diesem Hintergrund besteht die Aufgabe der Erfindung darin, eine Leuchtdiode anzugeben, die den Stand der Technik weiterbildet.

Die Aufgabe wird durch eine Leuchtdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Leuchtdiode mit einer stapelförmigen Struktur bereitgestellt, wobei die stapelförmige Struktur eine Trägerschicht und eine Spiegelschicht und eine n-dotierte untere Mantelschicht und eine aktive elektromagnetische Strahlung erzeugende Schicht und eine p-dotierte obere Mantelschicht und eine n-dotierte Stromverteilerschicht umfasst und die vorgenannten Schichten in der genannten Reihenfolge angeordnet sind.

Die aktive Schicht umfasst eine Quantentopfstruktur. Zwischen der oberen Mantelschicht und der Stromverteilerschicht ist eine Tunneldiode angeordnet, wobei die Stromverteilerschicht überwiegend aus einer n-dotierten Ga-haltigen Schicht, mit einem Ga-Gehalt > 1% besteht.

Es sei angemerkt, dass es sich bei den Prozentangaben bei Elementen wie beispielsweise bei Ga oder Al oder In jeweils um die Angabe des Verhältnisses der Anzahl der Atome der Gruppe III-Elemente der chemischen Verbindung der jeweiligen Schicht handelt. So meint die Angabe Al_{0.1}Ga_{0.9}As eine Schicht aus einem Halbleitermaterial, bei dem 50% der Atome Gruppe V-Elemente sind (As) und 50% der Atome Gruppe III-Elemente sind, wobei die Gruppe III Elemente wiederum zu 10% aus Al-Atomen und zu 90% aus Ga-Atomen gebildet werden. Analog wird die Nomenklatur bei Mischungen der Gruppe V Elemente bei Halbleitermaterialien wie GaAs_{0.8}P_{0.2} verwendet.

Es versteht sich, dass der Begriff der stapelförmigen Struktur aufeinander angeordnete Halbleiterschichten umfasst. Vorzugsweise sind die Schichten beginnend von der n-Mantelschicht bis einschließlich der n-Kontaktschicht monolithische ausgebildet und sind insbesondere mittels einer MOVPE Epitaxie hergestellt. Je nach Herstellung lassen sich die monolithisch ausgebildeten Schichten auch auf eine Trägerschicht bonden.

Es versteht sich, dass die auf der aktiven Schicht aufliegenden weiteren Schichten, inklusive der Schichten der Tunneldiode möglichst transparent für die Emissionswellenlänge der aktiven Schicht ausgebildet sind.

Ein Vorteil der vorliegenden Struktur ist, dass sich die Lichtausbeute auf einfache und kostengünstige Weise erhöhen lässt, während die Polarität der Struktur, bei der sich der p-Bereich oberhalb der aktiven Schicht befindet, beibehalten werden kann. Herkömmliche LEDs mit p-Bereich oberhalb der aktiven Zone weisen sehr geringe Lichtausbeuten auf. Eine höhere Lichtleistung kann nur mit Dünnfilm-LEDs mit integriertem Metallspiegel erreicht werden. Diese weisen allerdings immer einen p-Bereich unterhalb der aktiven Schicht auf. Mit "unterhalb der aktiven" Schicht ist hier immer eine Schicht gemeint, die bezüglich der Lichtauskopplung auf der abgewandten Seite liegt, mit "oberhalb der aktiven Schicht" ist eine Schicht gemeint, die auf der der Lichtauskoppelseite zugewandten Seite liegt.

Ein p-Bereich oberhalb der aktiven Zone kann bei diesen Bauteilen nur durch einen aufwendigen und kostenintensiven zusätzlichen Bondprozess sowie einem zusätzlichen Hilfsträgermaterial erreicht werden. Mit der vorliegenden Struktur mit Tunneldiode oberhalb der aktiven Schicht und Polaritätsumkehr kann auf einfache und günstige Art und Weise eine höhere Lichtleistung erreicht werden, in dem die Absorptionsverluste in der n-Stromverteilschicht geringer und die Querleitfähigkeit der n-Stromverteilschicht höher ist als bei entsprechender p-Polarität. Überraschenderweise hat sich dabei gezeigt, dass die Lichtausbeute trotz Einbau der Tunneldiode und Polaritätsumkehr der Schichten auf der aktiven Schicht im Vergleich zu einer Stand der Technik Schichtenfolge mit n-Mantelschicht zwischen der aktiven Schicht und der n-Stromverteilerschicht mindestens vergleichbar ist, dabei aber eine vorteilhafte Polarität der Gesamtstruktur aufweist. Weiterhin bleibt der Vorteil des im Vergleich zu einer p-Kontaktschicht wesentlich niedrigen Kontaktwiderstandes einer n-Kontaktschicht erhalten.

Anders ausgedrückt, eine Spiegelschicht zur Erhöhung der Effizienz wird aus Kostengründen bisher nur bei high Power LEDs angewendet. Der Fachmann verbleibt dann jedoch immer bei der n-up Struktur, d.h. ohne den Einbau einer Tunneldiode, um die notwendigen Querleitfähigkeiten aufgrund der geringeren effektiven Masse der Elektronen in den n-Schichten zu erhalten.

Hohe Stromdichten bei high Power p-up LED erfordern jedoch immer eine transparente und sehr gut elektrisch leitfähige Tunneldiode. Überraschenderweise lässt sich eine derartige Tunneldiode auf einfache und kostengünstige Weise insbesondere mit Tellur und Kohlenstoff dotierten Arsenid- und Phosphidschichten ausbilden.

Ein anderer Vorteil ist, dass die High-Power p-up LEDs einfach gegen die bisherigen "normalen" p-up LEDs austauschen lassen, ohne dass ein völliges Neudesign notwendig ist.

In einer Weiterbildung ist auf der Stromverteiierschicht eine Kontaktschicht ausgebildet, wobei die Stromverteilerschicht eine gleiche Polarität in der Dotierung wie die Kontaktschicht aufweist. Vorzugsweise ist die Dotierung der Kontaktschicht höher als die Dotierung der Stromverteilerschicht.

In einer Ausführungsform umfasst die stapelförmige Struktur überwiegend monolithisch angeordnete Schichten, wobei ein Teil der Schichten Gruppe-III-Arsenid-Verbindungshalbleiter und / oder Gruppe-III-Phosphid-Verbindungshalbleiter enthalten.

In einer anderen Weiterbildung weist die aktive Schicht eine Emissionswellenlänge größer als 600nm oder größer als 700 nm auf.

In einer Weiterbildung umfasst oder besteht die Trägerschicht aus Silizium oder Germanium oder Nickel oder GaAs. Vorzugsweise weist die Trägerschicht an der Unterseite ganzflächig einen ersten Anschlusskontakt auf. In einer Ausführungsform Ist unterhalb der n-dotierten unteren Mantelschicht eine n-dotierte Kontaktschicht ausgebildet.

In einer anderen Ausführungsform umfasst oder besteht die Spiegelschicht aus einer Metallschicht. Hierbei bildet die Metallschicht einen elektrischen Kontakt zwischen dem Träger und der unteren Mantelschicht und / oder der n-dotieren unteren Kontaktschicht aus. In einer anderen Ausführungsform umfasst die Spiegelschicht einen Halbleiterspiegel.

In einer Weiterbildung umfassen die untere Mantelschicht und die obere Mantelschicht (20) überwiegend Verbindungen aus GaAs oder aus AlGaAs oder aus InGaAsP oder aus GaAsP oder aus InGaP oder aus AlInGaP.

In einer anderen Weiterbildung umfasst die Quantentopfstruktur eine Mehrfach-Quantentopfstruktur, wobei die Mehrfach-Quantentopfstruktur eine Dicke zwischen 15nm und 350nm oder eine Dicke zwischen 30 nm und 300nm aufweist. In einer Ausführungsform besteht die aktive Schicht aus einer InₓGa₁₋ₓAs/GaAs_{1-y}P_{y} Mehrfach-Quantentopfstruktur mit 0,1 ≤ x ≤ 0,2 und 0,1 ≤ y ≤ 0,3 oder aus einer AlₓGa₁₋ₓAs/Al_{y}Ga_{1-y}As Mehrfach-Quantentopfstruktur mit 0 ≤ x ≤ 0,25 und 0,2 ≤ y ≤ 0,85.

In einer Ausführungsform weist die n-dotierte Stromverteilerschicht eine Dicke zwischen von 0,1 µm bis 5,0 µm auf. Vorzugsweise besteht die Stromverteilerschicht aus einer GaAs oder AlGaAs oder InGaP oder InAlP oder AlInGaP Verbindung. Insbesondere umfasst die Stromverteilerschicht eine n-dotierte AlₓGa₁₋ₓAs-Schicht mit einem Al-Gehalt x zwischen 0% und 20% umfasst. In einer Weiterbildung weist die Stromverteilerschicht eine n- Dotierstoffkonzentration größer als 1,0E18 N/cm³ auf. Untersuchungen haben gezeigt, dass es vorteilhaft ist, wenn die Stromverteilerschicht einen Schichtwiderstand Rs < 70 Ω/■ und die Mantelschicht einen Schichtwiderstand Rs > 400 Ω/■ aufweist.

Die Tunneldiode umfasst eine As-haltige Schicht und/oder eine P-haltige Schicht, wobei die As-haltige Schicht mit Kohlenstoff dotiert ist und/oder die P-haltige Schicht mit Tellur dotiert ist. Die Tunneldiode umfasst eine n-dotierte Schicht mit einer Dotierstoffkonzentration größer als 3x10¹⁸ N/cm³ und eine p-dotierte Schicht mit einer Dotierstoffkonzentration größer als 1x10¹⁹ N/cm³.

Erfindungsgemäss weist die Stromverteilerschicht eine Aussparung auf, wobei die Aussparung eine oberseitige Randfläche und eine Seitenfläche und eine Bodenfläche umfasst und wobei die Stromverteilerschicht an der Bodenfläche vollständig entfernt ist und die Bodenfläche mit einem gegenüber dem ersten Halbleitermaterial unterschiedlichen Füllmaterial bedeckt ist, und der Kontaktwiderstand zwischen dem Füllmaterial und der Bodenfläche größer als der Kontaktwiderstand zwischen dem Füllmaterial und der Stromverteilschicht ist. Die Aussparung ist überwiegend oder vorzugsweise vollständig mit dem Füllmaterial aufgefüllt. Das Füllmaterial stellt ein Teil des Vorderseitenkontakts dar und weist wenigstens an der Oberseite eine metallische Leitfähigkeit auf.

In einer anderen Ausführungsform sind der Randbereich und / oder die Seitenfläche wenigstens teilweise oder vollständig mit dem Füllmaterial bedeckt. Vorzugsweise wird die Aussparung vollständig mit dem Füllmaterial ausgefüllt. Vorzugsweise enthält das Füllmaterial Au und/oder Ni und/oder Pd und/oder Pt und/oder Ag.

In einer Weiterbildung umfasst das Füllmaterial eine metallische Verbindung, wobei die metallische Verbindung an der Bodenfläche wenigstens einen 10 fach größeren Kontaktwiderstand als zu der Seitenfläche und /oder zu der Randfläche ausbildet.

In einer anderen Weiterbildung ist an den Grenzflächen zwischen Füllmaterial und den das Füllmaterial umgebenden Schichten eine chemische Verbindung oder eine Legierung oder eine Halbleiterzwischenschicht ausgebildet.

Untersuchungen haben gezeigt, dass es vorteilhaft ist, wenn das Füllmaterial einen Dotierstoff für eine Dotierung der Grenzflächen mit den umgebenden Schichten enthält. Hierbei diffundiert der Dotierstoff aus dem Füllmaterial in die angrenzenden Schichten. Vorzugsweise weist das Füllmaterial einen Dotierstoff mit der Polarität des Dotierstoffes der Stromverteilerschicht auf.

In einer Ausführungsform weist das Füllmaterial und oder die Stromverteilerschicht und die Kontaktschicht eine Dotierung mit einem oder mehreren der Elemente Si, Ge, und Te auf. In einer anderen Ausführungsform ist in dem Bereich des Bodens ein Schottky-Kontakt ausgebildet.

In einer Weiterbildung durchdringt die Aussparung die Tunneldiodenschichtstruktur nicht oder teilweise oder vollständig. Vorzugsweise ist wenigstens ein Teil der Bodenfläche der Aussparung in dem Bereich der oberen Mantelschicht ausgebildet ist.

In einer anderen Weiterbildung ist die Aussparung kreisförmig oder oval oder eckig ausgebildet ist, wobei die Fläche der Aussparung maximal 25% der Fläche der aktiven Schicht beträgt.

Vorzugsweise ist die Aussparung in der Stromverteilerschicht in der Nähe des Flächenschwerpunkts der Schicht angeordnet. Höchst vorzugsweise umfasst die Aussparung den Flächenschwerpunkt, d.h. die Aussparung ist in der Mitte der Fläche ausgebildet. Anders ausgedrückt, die Aussparung ist zentrisch oder exzentrisch auf der Oberfläche der Leuchtdiode angeordnet. In einer Ausführungsform ist auf der Oberfläche des Füllmaterials innerhalb der Aussparung ein zweiter Anschlusskontakt in Form eines Bonds, vorzugsweise in Form eines Drahtbonds ausgebildet.

In einer Weiterbildung sind ausgehend von der Aussparung mehrere elektrisch leitende Finger auf der Oberfläche der Leuchtdiode angeordnet, wobei die Finger elektrisch mit dem zweiten Anschlusskontakt verbunden sind.

Die Erfindung wird nachfolgend unter Bezugnahme auf die Zeichnungen näher erläutert. Hierbei werden gleichartige Teile mit identischen Bezeichnungen beschriftet. Die dargestellten Zeichnungen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine Ansicht auf eine nicht erfindungsgemäße Ausführungsform eines LED-Schichtstapels,
- Figur 2: eine detaillierte Ansicht auf die Tunneldiode der Figur 1,
- Figur 3: eine detaillierte Ansicht auf den Aufbau der aktiven Schicht der Figur 1,
- Figur 4: eine detaillierte Ansicht auf eine erfindungsgemässe Ausführungsform eines LED-Schichtstapels,

- Figur 5: eine vollständige Ansicht auf eine erfindungsgemässe Ausführungsform eines LED-Schichtstapels und Veranschaulichung der bevorzugten Emissionsbereichen bei der aktiven Schicht.

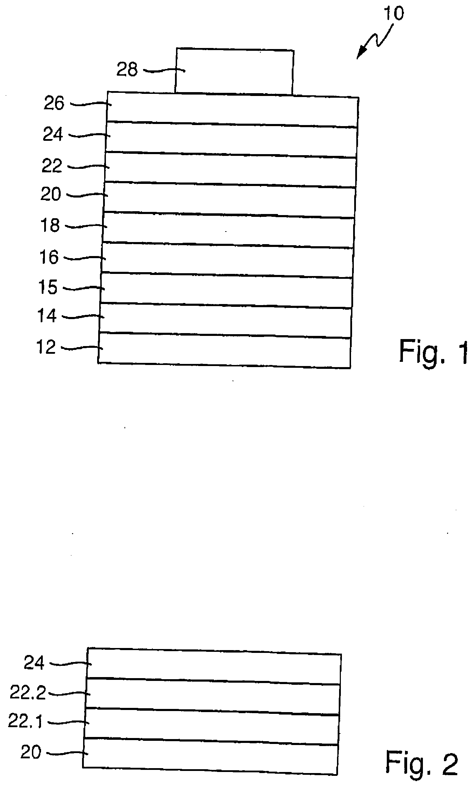

Die Abbildung der Figur 1 zeigt eine Ansicht auf eine nicht erfindungsgemäße

Ausführungsform einer Leuchtdiode 10. Die Leuchtdiode 10 weist eine stapelförmige Struktur mit senkrecht aufeinander angeordneten Schichten auf. Auf einer Rückseitenkontaktschicht 12 ist eine Trägerschicht 14 ausgebildet. Auf der Trägerschicht 14 ist eine Spiegelschicht 15 angeordnet. Auf der Spiegelschicht 15 ist eine n-dotierte untere Mantelschicht 16 ausgebildet. Vorzugsweise ist die Spiegelschicht 15 aus einer Metallschicht gebildet ist. Die Metallschicht bildet einen guten elektrischen Kontakt zwischen der Trägerschicht 14 und der unteren Mantelschicht 16 oder einer nicht dargestellten n-dotierten Kontaktschicht, die sich noch unterhalb der unteren Mantelschicht 16 befindet.

Auf der unteren Mantelschicht 16 ist eine aktive elektromagnetische Strahlung erzeugende Schicht 18 angeordnet, wobei die aktive Schicht 18 eine Quantentopfstruktur umfasst. Auf der aktiven Schicht 18 ist eine p-dotierte obere Mantelschicht 20 ausgebildet. Auf der oberen Mantelschicht 20 ist eine Tunneldiode 22 angeordnet. Auf der Tunneldiode 22 ist eine n-dotierte Stromverteilerschicht 24 ausgebildet. Auf der n-dotierte Stromverteilerschicht 24 ist eine n-dotierte Kontaktschicht 26 angeordnet. Die Stromverteilerschicht 24 weist vorwiegend eine n-dotierte Ga-haltige Schicht mit einem Ga-Gehalt von größer als 1% auf.

Auf der n-dotierten Kontaktschicht 26 ist ein Vorderseitenkontakt 28 angeordnet. Es versteht sich, dass der Vorderseitenkontakt 28 im Unterschied zu der Rückseitenkontaktschicht 12 nicht ganzflächig ausgebildet ist. Auch sei angemerkt, dass die genannten Schichten in der vorgenannten Reihenfolge angeordnet sind.

In der Abbildung der Figur. 2 ist eine detaillierte Ansicht auf die Tunneldiode der Figur 1 dargestellt. Im Folgenden werden nur die Unterschiede zu der Darstellung in der Figur 1 erläutert. Die Tunneldiode 22 weist eine erste auf der oberen Mantelschicht 20 angeordnete p-dotierte Schicht 22.1 auf. Die Dotierung der ersten Schicht ist größer als 1 x 10¹⁹ N/cm³. Vorzugsweise umfasst die erste Schicht As, wobei die erste Schicht mit Kohlenstoff dotiert ist.

Auf der ersten Schicht 22.1 ist eine zweite n-dotierte Schicht 22.2 angeordnet. Die Dotierung der zweiten Schicht ist größer als 3 x 10¹⁸ N/cm³. Vorzugsweise umfasst die zweite Schicht P, wobei die zweite Schicht mit Tellur dotiert ist.

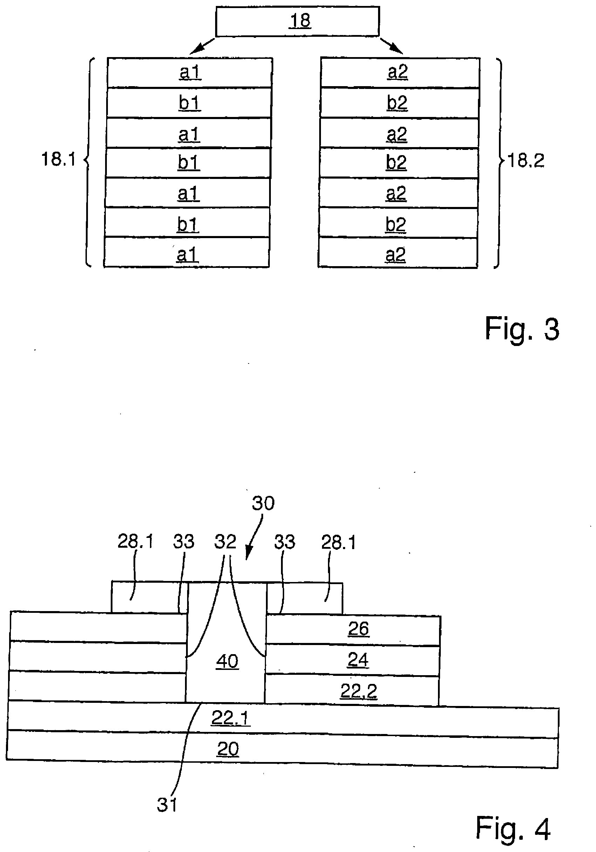

In der Abbildung der Figur. 3 ist eine detaillierte Ansicht auf die aktive Schicht 18 der Figur 1 dargestellt. Im Folgenden werden nur die Unterschiede zu der Darstellung in der Figur 1 erläutert. Für die aktive Schicht ist in einer ersten Alternative ein erster als Vielfachquantentopfstruktur ausgebildeter Schichtstapel 18. 1 und in einer zweiten Alternative ein zweiter ebenfalls als Vielfachquantentopfstruktur ausgebildeter Schichtstapel 18. 2 abgebildet.

Der erste Schichtstapel 18.1 weist eine Abfolge von einer ersten Schicht a1 und einer zweiten Schicht b1 auf. Die Abfolge wiederholt sich vorliegend genau drei Mal. Als oberste Schicht des ersten Schichtstapels 18.1 ist die erste Schicht a1 angeordnet. Die erste Schicht a1 ist 20 nm dick und besteht aus einer GaAs_{0.8}P_{0.2} Verbindung. Die zweite Schicht b1 ist 10 nm dick und besteht aus einer In_{0.15}Ga_{0.85}As Verbindung.

Der zweite Schichtstapel 18.2 weist eine Abfolge von einer ersten Schicht a2 und einer zweiten Schicht b2 auf. Die Abfolge wiederholt sich vorliegend genau drei Mal. Als oberste Schicht des zweiten Schichtstapels 18.2 ist die erste Schicht a2 angeordnet. Die erste Schicht a2 ist 20 nm dick und besteht aus einer Al_{0.5}Ga_{0.5}As Verbindung. Die zweite Schicht b2 ist 10 nm dick und besteht aus einer Al_{0.15}Ga_{0.85}As Verbindung.

In der Abbildung der Figur. 4 ist eine detaillierte Ansicht auf eine erste erfindungsgemässe Ausführungsform eines LED-Schichtstapels dargestellt. Im Folgenden werden nur die Unterschiede zu der Darstellung in der Figur 1 erläutert.

Ein oberer Teil der stapelförmigen monolithischen Struktur der Leuchtdiode 10 weist eine kreisförmige oder ovale oder rechteckige Aussparung 30 mit einem Boden 31, mit einer Seitenfläche 32 und einer oberseitigen Randfläche 33 auf. Die Aussparung 30 ist in dem Zentrum der Fläche - nicht dargestellt - der n-dotierten Kontaktschicht 26 angeordnet und durchdringt die n-dotierte Kontaktschicht 26 und die darunterliegende n-dotierte Stromverteilerschicht 24 sowie die zweite Schicht 22.2 der Tunneldiode 22 vollständig und liegt in Figur 4 oberhalb der ersten Schicht 22. 1 der Tunneldiode 22. Es versteht sich, dass je nach Dauer und Art des Ätz- oder Strukturierungsprozess der Boden 31 der Aussparung 30 unterschiedlich tief in der ersten Schicht 22.1 ausgebildet ist.

Die Fläche der Aussparung beträgt maximal 25% der Fläche der aktiven Schicht. Andernfalls wird die lichtaussendende Fläche der n--dotierten Kontaktschicht 26 zu gering.

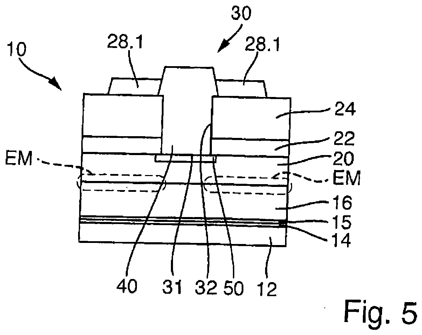

Es versteht sich, dass in einer anderen erfindungsgemässen Ausführungsform, dargestellt in der Figur 5, der Boden 31 der Aussparung 30 bei oder innerhalb der oberen Mantelschicht 20 ausgebildet ist, wobei es je nach Dauer und Art des Trockenätzprozesses der Boden 31 der Aussparung 30 unterschiedlich Tief in der oberen Mantelschicht 20 angeordnet ist.

Die Aussparung 30 wird mit einem im Vergleich zu dem umgebenden Halbleitermaterial der Schichten 20, 22.1, 22.2, 24, 26 unterschiedlichen Füllmaterial 40 gefüllt. Vorzugsweise umfasst das Füllmaterial 40 Au und/oder Ni und/oder Pd und/oder Pt und/oder Ag.

Die Aussparung 30 ist überwiegend oder vorzugsweise vollständig mit dem Füllmaterial 40 aufgefüllt. Das Füllmaterial 40 stellt ein Teil des Vorderseitenkontakts 28 dar und weist wenigstens an der Oberseite eine metallische Leitfähigkeit auf. Der Kontaktwiderstand zwischen dem Füllmaterial 40 und dem Boden 31 ist wenigstens 10-fach größer als der Kontaktwiderstand zwischen dem Füllmaterial 40 und der Stromverteilschicht 24. Ein unerwünschter Stromfluss durch den Boden 31 senkrecht hin zur aktiven Schicht 18 wird unterdrückt.

Vorzugsweise ist der Kontaktwiderstand zwischen dem Füllmaterial 40 und der Bodenfläche 31 größer als zu den an den Seitenflächen aufgeschlossenen Schichten 22.2, 24, 26.

In einer nicht dargestellten Ausführungsform ist in dem Bereich des Bodens 31 und / oder an den Seitenflächen 32 eine Isolationsschicht ausgebildet.

Die Isolationsschicht lässt sich beispielsweise vor dem Einbringen des Füllmaterials 40 ausbilden. Eine andere Möglichkeit ist, dass der Halbleiter/die Mantelschicht selbst durch Ausdiffusion eines Dotierstoffes aus dem Füllmaterial eine Isolationsschicht ausbildet.

Das Füllmaterial 40 enthält einen Dotierstoff für eine Dotierung der Grenzflächen 31 und 32 zwischen Füllmaterial. Als Dotierung weist das Füllmaterial 40 eines oder mehrere der Elemente Si, Ge, und Te auf. Das Füllmaterial 40 weist in einer nicht dargestellten Ausführungsform einen Schottky-Kontakt im Bereich des Bodens 31 auf.

Auf der oberseitigen Randfläche 33 sind als Teil des Vorderseitenkontakts 28 Metallleiterbahnen in Form von Fingern 28.1 ausgebildet, um die n-dotierte Kontaktschicht 26 an der Oberfläche möglichst niederohmig anzuschließen. Alle Finger 28.1 sind mit dem Füllmaterial 40 niederohmig verbunden. In einer ebenfalls nicht dargestellten Ausführungsform ist auf der Oberseite des Füllmaterials ein Drahtbond als Teil eines zweiten Anschlusskontakts ausgebildet.

In der Abbildung der Figur 5 ist eine Ansicht auf eine zweite erfindungsgemässe Ausführungsform eines LED-Schichtstapels mit Veranschaulichung der bevorzugten Emissionsbereiche bei der aktiven Schicht dargestellt. Im Folgenden werden nur die Unterschiede zu der Ausführungsform dargestellt in der Figur 4 erläutert.

Indem die Stromverteilerschicht 24 bereits eine gute elektrische Leitfähigkeit und einen niedrigen Kontaktwiderstand zum oberen zweiten Anschlusskontakt aufweist, erübrigt sich die Ausbildung der n-dotierten Kontaktschicht 26. Ein Vorteil ist, dass sich Emissionsrate der Leuchtdiode 10 erhöht.

Der Boden 31 der Aussparung 30 ist an der oder innerhalb der oberen Mantelschicht 20 ausgebildet. Im Bereich des Bodens 3 ist ein Schottkykontaktbereich 50 ausgebildet, mit dem ein Stromfluss vertikal zu der aktiven Schicht 18 wirkungsvoll unterdrückt wird.

Die Trägerschicht 14 ist sehr dünn ausgebildet und weist eine Dicke zwischen 100µm bis 450µm auf. Das Füllmaterial 40 umfasst eine PdGe Verbindung.

Links und rechts neben dem Bodenbereich zeigen sich zwei Emissionsbereiche EM von der aktiven Schicht 18. In einer nicht dargestellten Ansicht sind die Emissionsbereiche vollständig umlaufend um die Aussparung 30 ausgebildet.

## Patentansprüche

1. Leuchtdiode (10) mit einer stapelförmigen Struktur aufweisend,
eine Trägerschicht (14),
eine n-dotierte untere Mantelschicht (16),
eine aktive elektromagnetische Strahlung erzeugende Schicht (18), wobei die aktive Schicht (18) eine Quantentopfstruktur umfasst,
eine p-dotierte obere Mantelschicht (20),
eine n-dotierte Stromverteilerschicht (24),
wobei die Schichten (14, 16, 18, 20, 24) in der genannten Reihenfolge angeordnet sind,
zwischen der oberen Mantelschicht (20) und der Stromverteilerschicht (24) eine Tunneldiode (22) angeordnet ist, wobei die Stromverteilerschicht (24)
eine n-dotierte Ga-haltige Schicht mit einem Ga-Gehalt > 1% aufweist, zwischen der Trägerschicht (14) und der n-dotierten unteren Mantelschicht (16)
eine Spiegelschicht (15) angeordnet ist,
unterhalb der n-dotierten unteren Mantelschicht (16) eine n-dotierte Kontaktschicht ausgebildet ist und
die Tunneldiode (22) eine n-dotierte Schicht (22.2) mit einer Dotierstoffkonzentration größer als 3x10¹⁸ N/cm³ und eine p-dotierte Schicht (22.1) mit einer Dotierstoffkonzentration größer als 1x10¹⁹ N/cm³ umfasst,
**dadurch gekennzeichnet, dass**
die Stromverteilerschicht (24) eine Aussparung (30) aufweist und die Aussparung (30) eine oberseitige Randfläche (33) und eine Seitenfläche (32) und eine Bodenfläche (31) aufweist, wobei die Stromverteilerschicht (24) an der Bodenfläche (31) vollständig entfernt ist und die Bodenfläche (31) mit einem gegenüber dem ersten Halbleitermaterial unterschiedlichen Füllmaterial (40) bedeckt ist, und der Kontaktwiderstand zwischen dem Füllmaterial (40) und der Bodenfläche (31) größer als der Kontaktwiderstand zwischen dem Füllmaterial (40) und der Stromverteilschicht (24) ist, und
die Tunneldiode (22) eine As-haltige Schicht und/oder eine P-haltige Schicht umfasst,
wobei die As-haltige Schicht mit Kohlenstoff dotiert ist und/oder die P-haltige Schicht mit Tellur dotiert ist.

2. Leuchtdiode (10) nach Anspruch 1, **dadurch gekennzeichnet, dass** auf der Stromverteilerschicht (24) eine Kontaktschicht (26) ausgebildet ist und die Stromverteilerschicht (24) eine gleiche Polarität in der Dotierung wie die Kontaktschicht (26) aufweist, wobei die n-Dotierung der Kontaktschicht (26) höher als die n-Dotierung der Stromverteilerschicht (24) ist.

3. Leuchtdiode (10) nach Anspruch 1 oder Anspruch 2, **dadurch gekennzeichnet, dass** die stapelförmige Struktur überwiegend monolithisch angeordnete Schichten umfasst und ein Teil der Schichten Gruppe-III-Arsenid-Verbindungshalbleiter und oder Gruppe-III-Phosphid-Verbindungs-halbleiter enthalten.

4. Leuchtdiode (10) nach einem oder mehreren der vorangegangenen Ansprüche, **dadurch gekennzeichnet, dass** die Spiegelschicht (15) aus einer Metallschicht gebildet ist und die Metallschicht einen elektrischen Kontakt zwischen dem Träger (14) und der unteren Mantelschicht (16) und / oder der unteren Kontaktschicht ausbildet.

5. Leuchtdiode (10) nach einem oder mehreren der vorangegangen Ansprüche, **dadurch gekennzeichnet, dass** die untere Mantelschicht (16) und die obere Mantelschicht (20) eine Verbindung aus GaAs oder aus AlGaAs oder aus InGaAsP oder aus GaAsP oder aus InGaP oder aus AlInGaP umfassen.

6. Leuchtdiode (10) nach einem oder mehreren der vorangegangen Ansprüche, **dadurch gekennzeichnet, dass** die Stromverteilerschicht (24) eine n-dotierte AlₓGa₁₋ₓAs-Schicht mit einem Al-Gehalt x zwischen 0% und 20% umfasst.

7. Leuchtdiode (10) nach einem oder mehreren der vorangegangen Ansprüche, **dadurch gekennzeichnet, dass** die aktive Schicht (18) aus einer InₓGa₁₋ₓAs/GaAs_{1-y}P_{y} Mehrfach-Quantentopfstruktur mit 0,1 ≤ x ≤ 0,2 und 0,1 ≤ y ≤ 0,3 oder aus einer AlₓGa₁₋ₓAs/Al_{y}Ga_{1-y}As Mehrfach-Quantentopfstruktur mit 0 ≤ x ≤ 0,25 und 0,2 ≤ y ≤ 0,85 besteht.

8. Leuchtdiode (10) nach einem oder mehreren der vorangegangen Ansprüche, **dadurch gekennzeichnet, dass** der Randbereich und/oder die Seitenfläche (32) wenigstens teilweise oder vollständig mit dem Füllmaterial (40) bedeckt sind.

9. Leuchtdiode (10) nach einem oder mehreren der vorangegangen Ansprüche, **dadurch gekennzeichnet, dass** das Füllmaterial (40) eine metallische Verbindung umfasst und die metallische Verbindung in dem Bereich des Bodens (31) wenigstens einen 10 fach größeren Kontaktwiderstand als zu der Seitenfläche (32) und /oder zu der Randfläche (33) ausbildet.

10. Leuchtdiode (10) nach einem oder mehreren der vorangegangen Ansprüche, **dadurch gekennzeichnet, dass** an den Grenzflächen (31, 32) zwischen Füllmaterial (40) und den das Füllmaterial (40) umgebenden Schichten eine chemische Verbindung oder eine Legierung oder eine Halbleiterzwischenschicht ausgebildet ist.

11. Leuchtdiode (10) nach einem oder mehreren der vorangegangen Ansprüche, **dadurch gekennzeichnet, dass** das Füllmaterial (40) einen Dotierstoff für eine Dotierung der Grenzflächen (31, 32) mit den umgebenden Schichten enthält.

12. Leuchtdiode (10) nach einem oder mehreren der vorangegangen Ansprüche, **dadurch gekennzeichnet, dass** das Füllmaterial (40) und oder die Stromverteilerschicht (24) und die Kontaktschicht (26) eine Dotierung mit einem oder mehreren der Elemente Si, Ge, und Te aufweist.

13. Leuchtdiode (10) nach einem oder mehreren der vorangegangen Ansprüche, **dadurch gekennzeichnet, dass** in dem Bereich des Bodens (31) ein Schottky-Kontakt ausgebildet ist.

14. Leuchtdiode (10) nach einem oder mehreren der vorangegangenen Ansprüche, **dadurch gekennzeichnet, dass** die Aussparung (30) die Tunneldiodenschichtstruktur (22.1, 22.2) nicht oder teilweise oder vollständig durchdringt.

15. Leuchtdiode (10) nach einem oder mehreren der vorangegangen Ansprüche, **dadurch gekennzeichnet, dass** wenigstens ein Teil der Bodenfläche (31) in dem Bereich der oberen Mantelschicht (20) ausgebildet ist.

## Claims

1. Light-emitting diode (10) with a stack-shaped structure, comprising
a carrier layer (14),
an n-doped lower casing layer (16),
an active layer (18) generating electromagnetic radiation, wherein the active layer (18) has
a quantum well structure,
a p-doped upper casing layer (20),
an n-doped current distributor layer (24),
wherein the layers (14, 16, 18, 20, 24) are arranged in the stated sequence,
a tunnel diode (22) is arranged between the upper casing layer (20) and the current distributor layer (24), wherein the current distributor layer (24) comprises an n-doped Ga-containing layer with a Ga content greater than 1%,
a reflecting layer (15) is arranged between the carrier layer (14) and the n-doped lower casing layer (16),
an n-doped contact layer is formed below the n-doped lower casing layer (16), and
the tunnel diode (22) comprises an n-doped layer (22.2) with a doping substance concentration greater than 3 x 10¹⁸ N/cm³ and a p-doped layer (22.1) with a doping substance concentration greater than 1 x 10¹⁹ N/cm³,
**characterised in that**
the current distributor layer (24) has a recess (30) and the recess (30) has an upper-side edge surface (33), a side surface (32) and a base surface (31), wherein the current distributor layer (24) is completely removed at the base surface (31) and the base surface (31) is covered with a filler material (40) which is different relative to the first semiconductor material, and the contact resistance between the filler material (40) and the base surface (31) is greater than the contact resistance between the filler material (40) and the current distributor layer (24) and the tunnel diode (22) has an As-containing layer and/or a P-containing layer, wherein the As containing layer is doped with carbon and/or the P-containing layer Is doped with tellurium.

2. Light-emitting diode (10) according to claim 1, **characterised in that** a contact layer (26) is formed on the current distributor layer (24) and the current distributor layer (24) has the same polarity in doping as the contact layer (26), wherein the n-doping of the contact layer (26) is higher than the n-doping of the current distributor layer (24).

3. Light-emitting diode (10) according to claim 1 or claim 2, **characterised in that** the stack-shaped structure comprises predominantly monolithically arranged layers and a part of the layers contains group III arsenide compound semiconductors and/or group III phosphide compound semiconductors.

4. Light-emitting diode (10) according to one or more of the preceding claims, **characterised in that** the reflecting layer (15) is formed from a metal layer and the metal layer forms an electrical contact between the carrier (14) and the lower casing layer (16) and/or forms the lower contact layer.

5. Light-emitting diode (10) according to one or more of the preceding claims, **characterised in that** the lower casing layer (16) and the upper casing layer (20) comprise a compound of GaAs or of AlGaAs or of InGaAsP or of GaAsP or of InGaP or of AlInGaP

6. Light-emitting diode (10) according to one or more of the preceding claims, **characterised In that** the current distributor layer (24) comprises an n-doped AlₓGa₁₋ₓAs layer with an Al content x between 0% and 20%.

7. Light-emitting diode (10) according to one or more of the preceding claims, **characterised in that** the active layer (18) consists of an InGa₁₋ₓAs/GaAs_{1-y}P_{y} multiple quantum well structure in which 0.1 ≤ y ≤ 0.3 or an AlₓGa₁₋ₓAs/Al_{y}Ga_{1-y}As multiple quantum well structure in which 0 ≤ x ≤ 0.25 and 0.2 ≤ y ≤ 0.85.

8. Light-emitting diode (10) according to one or more of the preceding claims, **characterised in that** the edge region and/or the side surface (32) is or are covered at least partly or completely with the filler material (40).

9. Light-emitting diode (10) according to one or more of the preceding claims, **characterised in that** the filler material (40) comprises a metallic compound and the metallic compound forms in the region of the base (31) a contact resistance which is at least 10 times greater than towards the side surface (32) and/or the edge surface (33).

10. Light-emitting diode (10) according to one or more of the preceding claims, **characterised in that** a chemical compound or an alloy or a semiconductor intermediate layer is formed at the boundary surfaces (31, 32) between a filler material (40) and the layers surrounding the filler material (40).

11. Light-emitting diode (10) according to one or more of the preceding claims, **characterised in that** the filler material (40) contains a doping substance for doping the boundary surfaces (31, 32) with the surrounding layers.

12. Light-emitting diode (10) according to one or more of the preceding claims, **characterised in that** the filler material (40) and/or the current distributor layer (24) and the contact layer (26) has or have doping with one or more of the elements Si, Ge and Te.

13. Light-emitting diode (10) according to one or more of the preceding claims, **characterised in that** a Schottky contact is formed in the region of the base (31).

14. Light-emitting diode (10) according to one or more of the preceding claims, **characterised in that** the recess (30) does not penetrate or partly or completely penetrates the tunnel diode layer structure (22.1, 22.2).

15. Light-emitting diode (10) according to one or more of the preceding claims, **characterised in that** at least a part of the base surface (31) is formed in the region of the upper casing layer (20).

## Revendications

1. Diode électroluminescente (10) avec une structure empilée, présentant
une couche de support (14),
une couche d'enveloppe inférieure à dopage n (16),
une couche (18) produisant un rayonnement électromagnétique actif, dans laquelle la couche active (18) comprend une structure de puits quantique,
une couche d'enveloppe supérieure à dopage p (20),
une couche de répartition de courant à dopage n (24),
dans laquelle les couches (14, 16, 18, 20, 24) sont disposées dans l'ordre indiqué, une diode tunnel (22) est disposée entre la couche d'enveloppe supérieure (20) et la couche de répartition de courant (24), dans laquelle la couche de répartition de courant (24) présente une couche à dopage n contenant du Ga avec une teneur en Ga > 1 %,
une couche miroir (15) est disposée entre la couche de support (14) et la couche d'enveloppe inférieure à dopage n (16),
une couche de contact à dopage n est formée en dessous de la couche d'enveloppe inférieure à dopage n (16), et
la diode tunnel (22) comprend une couche à dopage n (22.2) avec une concentration en substance dopante supérieure à 3x10¹⁸ N/cm³ et une couche à dopage p (22.1) avec une concentration en substance dopante supérieure à 1x10¹⁹ N/cm³,
**caractérisée en ce que**
la couche de répartition de courant (24) présente une découpe (30) et la découpe (30) présente une face de bord supérieure (33) et une face latérale (32) et une face de fond (31), dans laquelle la couche de répartition de courant (24) est entièrement enlevée à la face de fond (31) et la face de fond (31) est recouverte d'un matériau de remplissage (40) différent par rapport au premier matériau semi-conducteur, et la résistance de contact entre le matériau de remplissage (40) et la face de fond (31) est supérieure à la résistance de contact entre le matériau de remplissage (40) et la couche de répartition de courant (24), et
la diode tunnel (22) comprend une couche contenant du As et/ou une couche contenant du P,
dans laquelle la couche contenant du As est dopée avec du carbone et/ou la couche contenant du P est dopée avec du tellure.

2. Diode électroluminescente (10) selon la revendication 1, **caractérisée en ce qu'**une couche de contact (26) est formée sur la couche de répartition de courant (24) et la couche de répartition de courant (24) présente une polarité identique au niveau du dopage à la couche de contact (26), dans laquelle le dopage n de la couche de contact (26) est plus élevé que le dopage n de la couche de répartition de courant (24).

3. Diode électroluminescente (10) selon la revendication 1 ou la revendication 2, **caractérisée en ce que** la structure empilée comprend des couches disposées de façon principalement monolithique et une partie des couches contiennent des semi-conducteurs composés groupe III-arséniure et/ou des semi-conducteurs composés groupe III-phosphure.

4. Diode électroluminescente (10) selon une ou plusieurs des revendications précédentes, **caractérisée en ce que** la couche miroir (15) est formée d'une couche métallique et la couche métallique forme un contact électrique entre le support (14) et la couche d'enveloppe inférieure (16) et/ou la couche de contact inférieure.

5. Diode électroluminescente (10) selon une ou plusieurs des revendications précédentes, **caractérisée en ce que** la couche d'enveloppe inférieure (16) et la couche d'enveloppe supérieure (20) comprennent un composé de GaAs ou de AlGaAs ou de InGaAsP ou de GaAsP ou de InGaP ou de AlInGaP.

6. Diode électroluminescente (10) selon une ou plusieurs des revendications précédentes, **caractérisée en ce que** la couche de répartition de courant (24) comprend une couche de AlₓGa₁₋ₓAs à dopage n avec une teneur en Al x comprise entre 0 % et 20 %.

7. Diode électroluminescente (10) selon une ou plusieurs des revendications précédentes, **caractérisée en ce que** la couche active (18) se compose d'une structure de puits quantique multiple InₓGa₁₋ₓAs/GaAs_{1-y}P_{y} avec 0,1≤x≤0,2 et 0,1≤y≤0,3 ou d'une structure de puits quantique multiple AlₓGa₁₋ₓAs/Al_{y}Ga_{1-y}As avec 0≤x≤0,25 et 0,2≤y≤0,85.

8. Diode électroluminescente (10) selon une ou plusieurs des revendications précédentes, **caractérisée en ce que** la zone de bord et/ou la face latérale (32) sont recouvertes au moins en partie ou entièrement avec le matériau de remplissage (40).

9. Diode électroluminescente (10) selon une ou plusieurs des revendications précédentes, **caractérisée en ce que** le matériau de remplissage (40) comprend un composé métallique et le composé métallique forme dans la région du fond (31) une résistance de contact au moins 10 fois plus élevée qu'avec la face latérale (32) et/ou la face de bord (33).

10. Diode électroluminescente (10) selon une ou plusieurs des revendications précédentes, **caractérisée en ce qu'**un composé chimique ou un alliage ou une couche intermédiaire semi-conductrice est formé(e) aux faces limites (31, 32) entre le matériau de remplissage (40) et les couches entourant le matériau de remplissage (40).

11. Diode électroluminescente (10) selon une ou plusieurs des revendications précédentes, **caractérisée en ce que** le matériau de remplissage (40) contient une substance dopante pour un dopage de faces limites (31, 32) avec les couches environnantes.

12. Diode électroluminescente (10) selon une ou plusieurs des revendications précédentes, **caractérisée en ce que** le matériau de remplissage (40) et/ou la couche de répartition de courant (24) et la couche de contact (26) présentent un dopage avec un ou plusieurs des éléments Si, Ge, et Te.

13. Diode électroluminescente (10) selon une ou plusieurs des revendications précédentes, **caractérisée en ce qu'**un contact de Schottky est formé dans la région du fond (31).

14. Diode électroluminescente (10) selon une ou plusieurs des revendications précédentes, **caractérisée en ce que** la découpe (30) ne traverse pas ou traverse partiellement ou entièrement la structure de couches de la diode tunnel (22.1, 22.2).

15. Diode électroluminescente (10) selon une ou plusieurs des revendications précédentes, **caractérisée en ce qu'**au moins une partie de la face de fond (31) est formée dans la région de la couche d'enveloppe supérieure (20).
